(19) Europäisches Patentamt
European Patent Office
Office européen des brevets

(11) **EP 0 366 294 B1**

(12) **EUROPEAN PATENT SPECIFICATION**

(45) Date of publication and mention
of the grant of the patent:
**02.07.1997 Bulletin 1997/27**

(51) Int Cl.$^6$: **H03K 19/0175**

(21) Application number: **89310266.5**

(22) Date of filing: **06.10.1989**

(54) **TTL-ECL level converting circuit**

TTL-ECL-Pegelumsetzungsschaltung

Circuit de conversion de niveaux TTL-ECL

(84) Designated Contracting States:
**DE FR GB**

(30) Priority: **06.10.1988 JP 252682/88**

(43) Date of publication of application:
**02.05.1990 Bulletin 1990/18**

(73) Proprietor: **NEC CORPORATION**
**Tokyo (JP)**

(72) Inventor: **Matsumoto, Kouji c/o NEC Corporation**
**Minato-ku Tokyo (JP)**

(74) Representative: **Abnett, Richard Charles et al**
**REDDIE & GROSE**
**16 Theobalds Road**
**London WC1X 8PL (GB)**

(56) References cited:
EP-A- 0 109 106     DE-A- 3 006 176
US-A- 4 771 191

- **PATENT ABSTRACTS OF JAPAN, vol. 11, no. 312 (E-548), 12th October 1987 & JP-A- 62 104 314**
- **RADIO FERNSEHEN ELEKTRONIK, vol. 37, no. 2, 1988, pages 124,129, Berlin, DE; G.**
- **TURINSKY: "Pegelwandlung ECL-TTL und umgekehrt"**
- **M. HERPY "Analoge Integrierte Schaltungen" 1979, FRANZIS-VERLAG, München, page 251**
- **E. KÜHN "Handbuch TTL- und CMOS-Schaltkreise" 1985, VEB VERLAG TECHNIK, Berlin, pages 317, 320**

## Description

The present invention relates to a TTL-ECL converting circuit, and more specifically to a TTL-ECL converting circuit which operates at a high speed and which is free from self-oscillation.

Recently, ECL (emitter coupled logic) circuits in the form of an integrated circuit having a high integration density have been used in various fields requiring high speed operation, for example, so-called main-frames, communication instruments, LSI testers, measuring instruments, etc. In many cases, however, the above mentioned instruments are provided, as a memory, with an inexpensive standard semiconductor memory having a TTL (transistor-transistor logic) interface. Therefore, interfaces for the ECL integrated circuit having a high integration density have been provided with TTL-ECL level converting circuits and therefore, both an ECL interface and a TTL interface have been assembled within a single LSI chip.

From document PATENT ABSTRACTS OF JAPAN, vol. 11, no. 312 (E-548), 12th October 1987; & JP-A-62 104 314 a TTL-ECL circuit is known that comprises a diode having a cathode connected to an input terminal for a TTL signal and an anode connected to a first connection terminal, a resistor having its one end connected to a high voltage supply line and its other end connected to said first connection node, a transistor having a collector connected to said high voltage supply line, a base connected to said first connection node and an emitter connected to a second connection node, a level shift means having its one end connected to said second connection node and its other end connected to a third connection node, a constant current source having its one end connected to said third connection node and its other end connected to a low voltage supply line, and an emitter follower connected between an intermediate voltage supply line and said low voltage supply line and having an input coupled to said third connection node and an output connected to an output terminal for an ECL signal.

However, the present inventor has appreciated that the conventional TTL-ECL level converting circuits have been disadvantageous in that the base potential of a transistor receiving a TTL input signal is apt to cause self-oscillation, and the fluctuating voltage is propagated as noise to an ECL level output signal. The noise has the possibility of causing the next ECL circuit stage to malfunction.

Furthermore, the conventional TTL-ECL level converting circuits have a logical amplitude of the ECL output signal much larger than the logical amplitude in ordinary ECL circuits. Therefore, the propagation delay time is inevitably large.

The present invention is defined in the appended claim 1, to which reference should now be made.

Advantageous features of the invention are set forth in the appendant claims.

Embodiments of the invention will now be described in more detail, by way of example, with reference to the accompanying drawings, in which:-

**Figure 1** is a circuit diagram of a proposed TTL-ECL level converting circuit;

**Figure 2** is a circuit diagram of one embodiment of the TTL-ECL level converting circuit in accordance with the present invention;

**Figures 3A, 3B and 3C** are circuit diagrams illustrating various modifications of the TTL-ECL level converting circuit shown in Figure 2; and

**Figures 4A and 4B** are voltage waveform diagrams illustrating the operation of the circuit shown in Figure 2 and a comparative circuit.

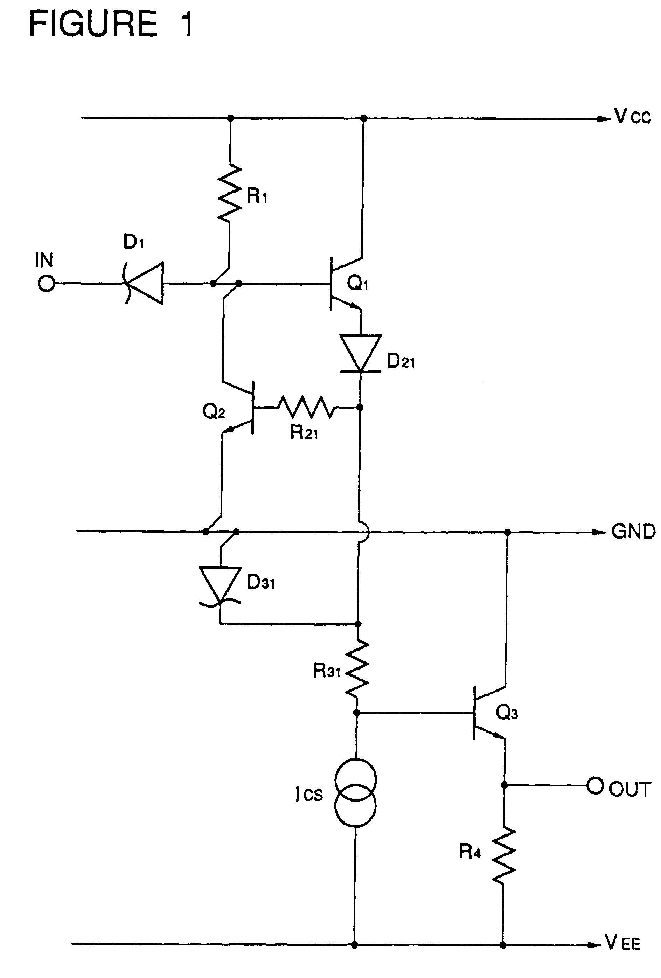

Referring to Figure 1, there is shown a circuit diagram of a proposed TTL-ECL level converting circuit. The circuit illustrated includes an input terminal IN for receiving a TTL level signal and an output terminal OUT for outputting an ECL level signal. The input terminal IN is connected to the cathode of a Schottky barrier diode $D_1$, whose anode is connected to one end of a resistor $R_1$, to the base of a first transistor $Q_1$ and to the collector of a second transistor $Q_2$, respectively. The other end of the resistor $R_1$ and the collector of the first transistor $Q_1$ are connected to a high voltage supply line $V_{CC}$. The emitter of the first transistor $Q_1$ is connected to a low voltage supply line $V_{EE}$ through a diode $D_{21}$, a resistor $R_{31}$ and a constant current source Ics. In addition, the emitter of the second transistor $Q_2$ is connected to a ground line GND, and the base of the second transistor $Q_2$ is connected through a resistor $R_{21}$ to a connection node between the diode $D_{21}$ and the resistor $R_{31}$. Another Schottky barrier diode $D_{31}$ is connected between the ground line GND and the connection node between the diode $D_{21}$ and the resistor $R_{31}$. Furthermore, there is provided a third transistor $Q_3$ having its collector connected to the ground line GND, and its base connected to a connection node between the resistor $R_{31}$ and the constant current source Ics. The emitter of the third transistor $Q_3$ is connected through a resistor $R_4$ to the low voltage supply line $V_{EE}$ and is also connected to the output terminal OUT.

The operation of the above mentioned TTL-ECL level converting circuit will now be explained. A TTL level signal applied to the input terminal IN is level-shifted by the diode $D_1$, the transistor $Q_1$, the diode $D_{21}$ and the resistor $R_{31}$,

and outputted as an ECL level signal from the output terminal OUT through an emitter follower formed of the transistor $Q_3$ and the resistor $R_4$.

The ECL level signal is set as follows: When the TTL level signal of a high level $V_{IH}$ is inputted, the transistor $Q_1$, the diode $D_{21}$ and the transistor $Q_2$ are brought into the on condition, and on the other hand, the diode $D_1$ is brought into the off condition. If a forward direction voltage of diodes and transistors is expressed by $V_F$, this input voltage $V_{IH}$ must fulfil the following condition (1) in order to render the diode $D_1$ off:

$$V_{IH} \geq V_F(Q_2) + V_F(D_{21}) + V_F(Q_1) - V_F(D_1) \tag{1}$$

In general, the forward direction operating voltage $V_F$ is 0.8 V in diodes and transistors, and 0.4 V in Schottky barrier diodes, and therefore, the high level condition becomes stable if $V_{IH} \geq 2.0$ V. In this condition, the high level output $V_{OH}$ of the ECL level signal is expressed by the following equation (2):

$$V_{OH} = V_F(Q_2) - R_{31} \cdot Ics - V_F(Q_3) \approx - R_{31} \cdot Ics \tag{2}$$

where Ics is the current value of the constant current source Ics)

On the other hand, when the TTL level signal of a low level $V_{IL}$ is inputted, the diodes $D_1$ and $D_{31}$ are brought into the on condition, and the transistor $Q_2$ is brought into the off condition. In this condition, in order to ensure the on condition of the diode $D_1$, the input voltage $V_{IL}$ must fulfil the following condition (3):

$$V_{IL} \leq -V_F(D_{31}) + V_F(D_{21}) + V_F(Q_1) - V_F(D_1) \tag{3}$$

Therefore, the low level condition becomes stable under the condition of $V_{IL} \leq 0.8V$.

In this condition, a low level output $V_{OL}$ of the ECL level signal is expressed by the following equation (4):

$$V_{OL} = -V_F(D_{31}) - R_{31} \cdot Ics - V_F(Q_3) \tag{4}$$

As seen from the equations (2) and (4), the ECL level output of the circuit shown in Figure 1 has a logical amplitude (a difference between $V_{OH}$ and $V_{OL}$) corresponding to the sum of the forward direction operating voltage of one transistor and the forward direction operating voltage of one Schottky barrier diode (about 1.2V).

In the circuit shown in Figure 1, when the input TTL level signal is brought from the low level to the high level, the base potential of the transistor $Q_1$ is elevated to follow the input TTL level signal, and the elevating potential is level-shifted by the transistor $Q_1$, the diode $D_{21}$ and the resistor $R_{21}$ and applied to the base of the transistor $Q_2$ so as to cause the transistor $Q_2$ to turn on. Namely, a current flows through the resistor $R_1$ with the result that a balanced and stable condition is established. In the above mentioned process, the present inventor has appreciated that a propagation delay will occur in the course of the level shifting, and therefore, the base potential of the transistor $Q_1$ is apt to cause oscillation due to a delay of the turning-on of the transistor $Q_2$ and a voltage drop caused across the resistor $R_1$ by an abruptly increasing operation current.

Specifically, when the input signal on the input terminal IN changes from the low level to the high level, the base potential of the transistor $Q_1$ elevates towards the potential of the high voltage supply $V_{CC}$ through the resistor $R_1$. This elevated voltage is propagated to the base of the transistor $Q_2$ through the transistor $Q_1$, the diode $D_{21}$ and the resistor $R_{21}$ with a delay corresponding to the propagation delay time of these elements. As a result, the current of the transistor $Q_2$ is increased, and the collector potential of the transistor $Q_2$ is correspondingly decreased due to the voltage drop across the resistor $R_1$. The drop of the collector potential of the transistor $Q_2$ is propagated to the base of the transistor $Q_2$ after a constant delay time, so that the base potential of the transistor $Q_2$ is decreased, and therefore, the collector current of the transistor $Q_2$ is correspondingly decreased. As result, the collector potential of the transistor $Q_2$ is elevated at this time.

The above mentioned operation is repeated and therefore the base potential of the transistor $Q_1$ fluctuates or oscillates. This oscillating waveform is level-shifted, and thereafter, is propagated as noises to the high level of the ECL level output signal. The noise has the possibility of cause the next ECL circuit stage to malfunction.

Furthermore, in the circuit shown in Figure 1 the logical amplitude of the ECL output signal corresponds to the sum of the forward direction operating voltage of one transistor $Q_2$ and the forward direction operating voltage of one Schottky barrier diode $D_{31}$. This logical amplitude of the ECL output signal is much larger than a logical amplitude of 0.6V in ordinary ECL circuits. Therefore, the propagation delay time inevitably becomes large.

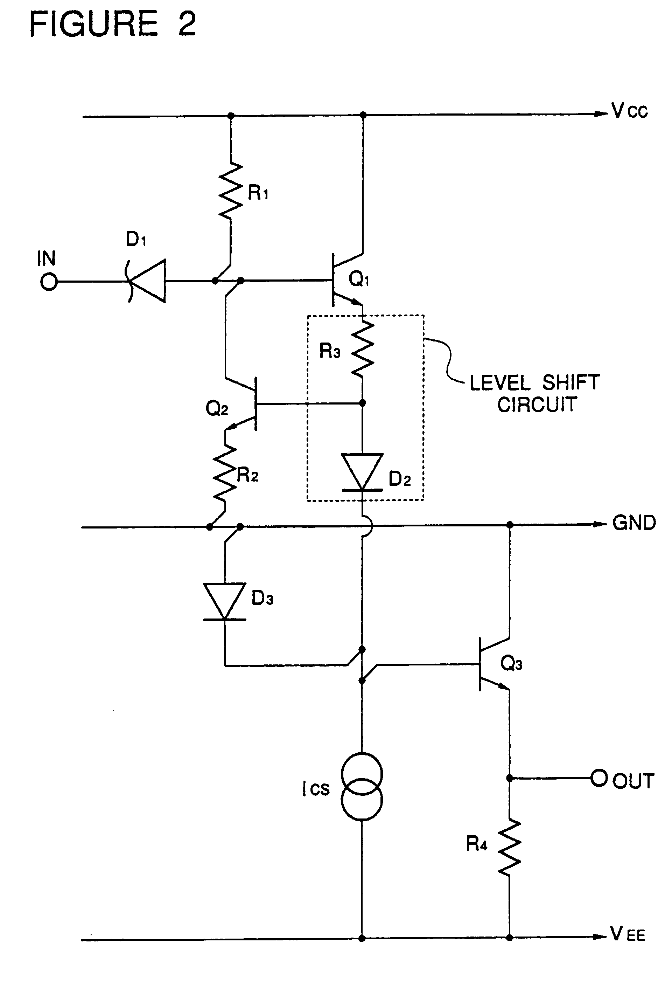

Referring to Figure 2, there is shown the circuit diagram of one embodiment of the TTL-ECL level converting circuit in accordance with the present invention. In Figure 2, elements similar or corresponding to those shown in Figure 1 are given the same reference characters, and explanation thereof will be omitted for simplification of description.

As seen from Figures 1 and 2, a level shift circuit in the conversion circuit shown Figure 2 connected to the emitter of the transistor $Q_1$ is composed of a series circuit consisting of a resistor $R_3$ and a diode $D_2$ in such a manner that the resistor $R_3$ is connected at its one end to the emitter of the transistor $Q_1$ and at its other end to the anode of the diode $D_2$, and the cathode of the diode $D_2$ is connected to the current source Ics. A connection node between the resistor $R_3$ and the diode $D_2$ is connected directly to the base of the transistor $Q_2$. In addition, a resistor $R_2$ is connected between the emitter of the transistor $Q_2$ and the ground line GND. The cathode of an anode-grounded diode $D_3$ for low level clamping is connected to the cathode of the diode $D_2$ which forms an output end of the level shift circuit.

The operation of the TTL-ECL level converting circuit shown in Figure 2 will now be explained. When the TTL level input signal is at a high level $V_{IH}$, the transistors $Q_1$ and $Q_2$ and the diode $D_2$ are brought into the on condition, and, on the other hand, the diodes $D_1$ and $D_3$ are brought into the off condition. In other words, the operation current of the transistor $Q_2$ flows through the resistor $R_1$ so that an anode potential of the diode $D_1$ is maintained at a constant level. Therefore, the voltage difference $V(D_1)$ between the anode potential of the diode $D_1$ and the high level TTL level signal applied at the cathode of the diode $D_1$ becomes smaller than the forward direction operation voltage $V_F(D_1)$ of the diode $D_1$, and therefore, the diode $D_1$ is turned off. With this, the status is balanced. In this condition, the operating current $I_F(Q_2)$ of the transistor $Q_2$ is expressed by the following equation (5):

$$I_F(Q_2) = \{V_{CC} - V_F(Q_1) - R_3 \cdot Ics - V_F(Q_2)\}/(R_1 + R_2) \tag{5}$$

In addition, the voltage difference $V(D_1)$ applied across the Schottky barrier diode $D_1$ is expressed by the following equation (6):

$$V(D_1) = V_F(Q_1) + R_3 \cdot Ics + V_F(Q_2) + R_2 \cdot I_F(Q_2) - V_{IH} \tag{6}$$

The condition for maintaining the Schottky diode $D_1$ in the off condition can be expressed by the following equation (6a):

$$V(D_1) < V_F(D_1) \tag{6a}$$

Here, assuming $V_F(Q_1) = V_F(Q_2) = 0.8V$, $R_3 = 2K\Omega$, Ics = 0.3mA, $R_2 = 1K\Omega$, $V_{CC} = 5V$, $R_1 = 20K\Omega$, $V_{IH} \geq 2.0V$, and $V_F(D_1) = 0.4V$, the above mentioned condition is fulfilled.

In this case, the high level $V_{OH}$ of the ECL level output is expressed by the following equation (7):

$$V_{OH} = R_2 \cdot I_F(Q_2) + V_F(Q_2) - V_F(D_2) - V_F(Q_3) \approx R_2 \cdot I_F(Q_2) - V_F(Q_3) \tag{7}$$

On the other hand, when the TTL level signal of a low level $V_{IL}$ is inputted, the diodes $D_1$ and $D_3$ are brought into the on condition, and the transistor $Q_2$ is brought into the off condition. In this condition, the cathode potential of the diode $D_2$ becomes a low voltage sufficient to turn on the diode $D_3$. The condition for this is expressed by the following equation (8):

$$|V_{IL} + V_F(D_1) - V_F(Q_1) - R_3 \cdot I_{CS} - V_F(D_2) | \geq V_F(D_3) \tag{8}$$

Here, assuming $V_{IL} \leq 0.8V$, $V_F(D_1) = 0.4V$, $V_F(Q_1) = V_F(D_2) = V_F(Q_3) = 0.8V$, $R_3 = 2K\Omega$, and Ics = 0.3mA, the above mentioned condition (8) is fulfilled.

In this condition, a low level output $V_{OL}$ of the ECL level signal is expressed by the following equation (9):

$$V_{OL} = - V_F(D_3) - V_F(Q_3) \tag{9}$$

As seen from the above equations (7) and (9), the logical amplitude of the ECL output signal of the converting circuit shown in Figure 2 is expressed by the following equation (10):

$$V_{OH} - V_{OL} = R_2 \cdot I_F(Q_2) + V_F(D_3) \qquad (10)$$

Here, if $I_F(Q_2)$ is calculated in accordance with the equation (5) in the example in which the respective elements have the above mentioned values, respectively, the logical amplitude of the ECL level output signal of the converting circuit shown in Figure 2 is about 0.93V, which is apparently smaller than that of the circuit shown in Figure 1. In addition, if a Schottky barrier diode is used as the diode $D_3$ and the value of the resistor $R_2$ is 1.5K$\Omega$, the logical amplitude of the ECL level output signal can be reduced to 0.6V under the condition that the equations (6a) and (8) are fulfilled.

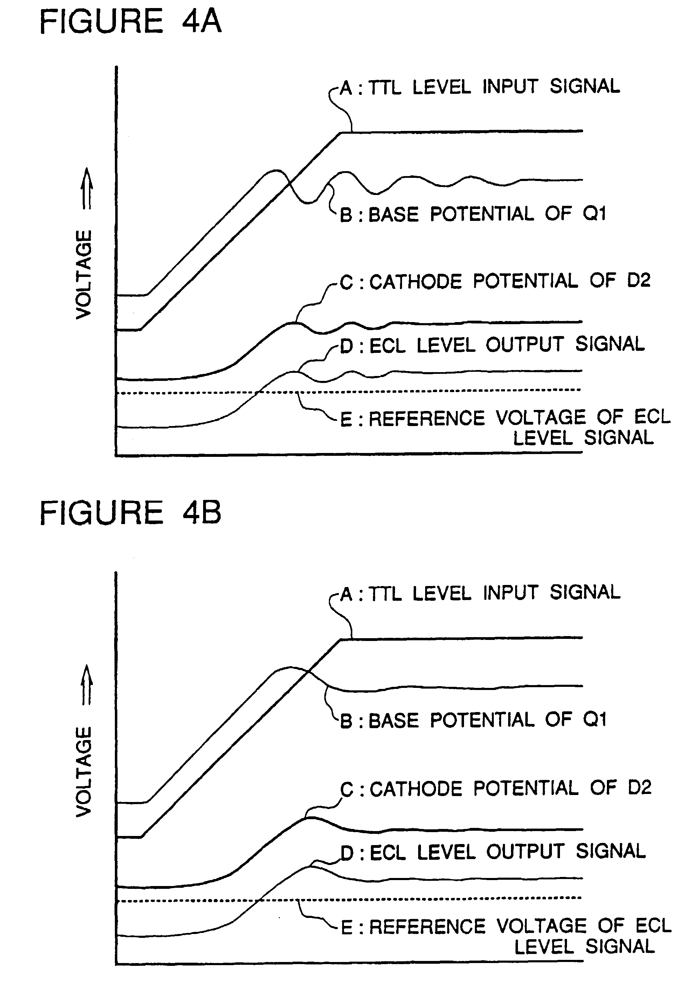

Next, an oscillation restraining effect obtained by inserting the resistor $R_2$ between the emitter of the transistor $Q_2$ and the ground line GND will be explained on the basis of the result of a simulation. Figure 4A shows a graph illustrating voltage variations on various points in the converting circuit shown in Figure 2 in which the resistor $R_2$ is removed and the emitter of the transistor $Q_2$ is directly connected to the ground line GND. Figure 4B is a graph illustrating voltage variations on various points in the converting circuit shown in Figure 2. These figures show transitions when the TTL input signal is brought from the low level to the high level. In each of these figures, the line A shows the TTL level input signal, and the line B shows the base potential of the transistor $Q_1$. The lines C, D and E indicate the cathode potential of the diode $D_2$, the ECL level output signal, and a reference voltage for the ECL level signal, respectively. In addition, the values of the respective elements used in the circuit for the simulation is in accordance with the values as mentioned hereinbefore.

As shown in Figure 4A, in the case of no resistor $R_2$, the base potential of the transistor $Q_2$ greatly oscillates, and therefore, the ECL level output signal correspondingly fluctuates. If this fluctuation exceeds the reference voltage for the ECL level signal indicated by the line E, a malfunction will occur. On the other hand, in the circuit shown in Figure 2, the oscillation of the base potential of the transistor $Q_1$ is almost perfectly restrained, and therefore, there is little possibility of malfunction.

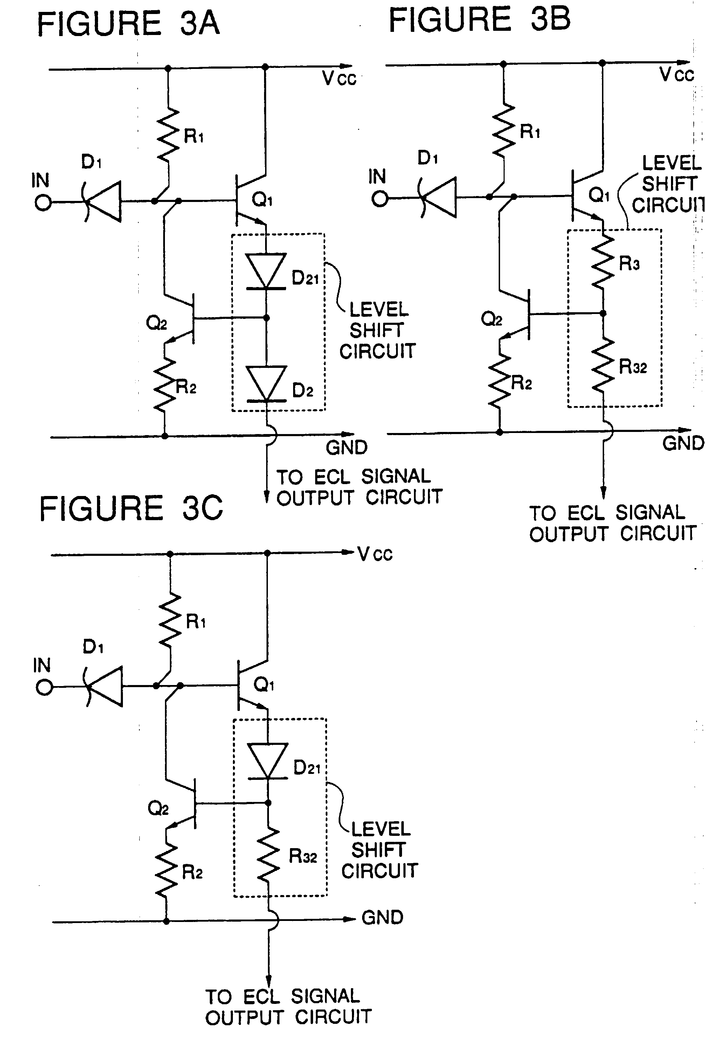

Turning to Figures 3A, 3B and 3C, there are shown some modifications of the level shift circuit portion of the converting circuit shown in Figure 2.

In the modification shown in Figure 3A, the level shift circuit is composed of a series circuit consisting of two diodes $D_{21}$ and $D_2$. In this modified converting circuit, since the level shift circuit is composed of a low impedance circuit formed of only the diodes, the propagation delay can be shortened to a minimum extent.

In the modification shown in Figure 3B, the level shift circuit is composed of a series circuit consisting of two resistors $R_3$ and $R_{32}$. In this modified converting circuit, since the constant current flows through the resistors of the level shift circuit, temperature dependency of the threshold of the converting circuit is eliminated. Ordinarily, the forward direction operating voltage of diodes and transistors has a temperature dependency of about 2mV/°C. In the circuit shown in Figure 2, the temperature dependencies of the Schottky barrier diode $D_1$ and the transistors $Q_1$ are countervailed or compensated to each other. In the modification shown in Figure 3B, on the other hand, the level shift circuit does not have a temperature dependency. As a result, the converting circuit modified in accordance with the modification shown in Figure 3B has a threshold with no temperature dependency. This is very advantageous in that even if the converting circuit and an ECL circuit which generates a large amount of heat due to power consumption are integrated in the same chip, the converting circuit maintains its threshold at a constant level regardless of temperature change.

In the modification shown in Figure 3C, the level shift circuit is composed of a series circuit consisting of a diode $D_{21}$ and a resistor $R_{32}$ in such a manner that the diode $D_{21}$ is connected at its anode to the emitter of the transistor $D_{21}$ and at its cathode to one end of the resistor $R_{32}$ and the base of the transistor $Q_2$. This modified converting circuit has an excellent balance concerning both the delay time and the threshold temperature dependency.

The invention has thus been shown and described with reference to the specific embodiments. However, it should be noted that the present invention is in no way limited to the details of the illustrated structures but changes and modifications may be made within the scope of the appended claims.

## Claims

1. A TTL-ECL converting circuit, comprising a Schottky barrier diode ($D_1$) having a cathode connected to an input terminal (IN) for a TTL signal and an anode connected to a first connection node, a resistor ($R_1$) having its one end connected to a high voltage supply line (Vcc) and its other end connected to said first connection node, a first transistor ($Q_1$) having a collector connected to said high voltage supply line, a base connected to said first connection node and an emitter connected to a second connection node, a level shift means ($R_3$, $D_2$; $D_{21}$, $D_2$; $R_3$, $R_{32}$; $D_{21}$, $R_{32}$) having its one end connected to said second connection node, an intermediate node forming a third connection node, and its other end connected to a fourth connection node, a constant current source (Ics) having its one end connected to said fourth connection node and its other end connected to a low voltage supply line (Vee), a second transistor ($Q_2$) having a collector connected to said first connection node, a base connected to said third connection node and an emitter connected through a second resistor ($R_2$) to an intermediate voltage supply line (GND), and an emitter follower ($Q_3$, $R_4$) connected between said intermediate voltage supply line and said low voltage supply line and having an input connected to said fourth connection node and an output connected to an output terminal (OUT) for an ECL signal.

2. A circuit claimed in claim 1, further including a diode ($D_3$) having its anode connected to said intermediate voltage supply line and its cathode connected to said fourth connection node.

3. A circuit claimed in claim 1 or 2, wherein said level shift means includes a resistor ($R_3$) having its one end connected to said second connection node and its other end connected to said third connection node, and a diode ($D_2$) having its anode connected to said third connection node and its cathode connected to said fourth connection node.

4. A circuit claimed in claim 1 or 2, wherein said level shift means includes a diode ($D_{21}$) having its anode connected to said second connection node and its cathode connected to said third connection node, and another diode ($D_2$) having its anode connected to said third connection node and its cathode connected to said fourth connection node.

5. A circuit claimed in claim 1 or 2, wherein said level shift means includes a resistor ($R_3$) having its one end connected to said second connection node and its other end connected to said third connection node, and another resistor ($R_{32}$) having its one end connected to said third connection node and its other end connected to said fourth connection node.

6. A circuit claimed in claim 1 or 2, wherein said level shift means includes a diode ($D_{21}$) having its anode connected to said second connection node and its cathode connected to said third connection node, and a resistor ($R_{32}$) having its one end connected to said third connection node and its other end connected to said fourth connection node.

**Patentansprüche**

1. TTL-ECL-Pegelumsetzungsschaltung mit einer Schottky-Diode ($D_1$), deren Katode mit einem Eingangsanschluß (IN) für ein TTL-Signal und deren Anode mit einem ersten Verbindungsknoten verbunden ist, einem Widerstand ($R_1$), dessen eines Ende mit einer Versorgungsleitung mit hoher Spannung ($V_{CC}$) und dessen anderes Ende mit dem ersten Verbindungsknoten verbunden ist, einem ersten Transistor ($Q_1$), dessen Kollektor mit der Versorgungsleitung mit hoher Spannung verbunden ist, dessen Basis mit dem ersten Verbindungsknoten und dessen Emitter mit einem zweiten Verbindungsknoten verbunden ist, einer Pegelverschiebungseinrichtung ($R_3$, $D_2$; $D_{21}$, $D_2$; $R_3$, $R_{32}$; $D_{21}$, $R_{32}$), deren eines Ende mit dem zweiten Verbindungsknoten verbunden ist, wobei ein Zwischenknoten einen dritten Verbindungsknoten bildet, und deren anderes Ende mit einem vierten Verbindungsknoten verbunden ist, einer Konstantstromquelle ($I_{CS}$), deren eines Ende mit dem vierten Verbindungsknoten und deren anderes Ende mit einer Versorgungsleitung mit niedriger Spannung ($V_{EE}$) verbunden ist, einem zweiten Transistor ($Q_2$), dessen Kollektor mit dem ersten Verbindungsknoten, dessen Basis mit dem dritten Verbindungsknoten und dessen Emitter über einen zweiten Widerstand ($R_2$) mit einer Versorgungsleitung mit Zwischenspannung (GND) verbunden ist, und einem Emitterfolger ($Q_3$, $R_4$), der zwischen die Versorgungsleitung mit Zwischenspannung und die Versorgungsleitung mit niedriger Spannung geschaltet ist, dessen Eingang mit dem vierten Verbindungsknoten und dessen Ausgang mit einem Ausgangsanschluß (OUT) für ein ECL-Signal verbunden ist.

2. Schaltung nach Anspruch 1, ferner mit einer Diode ($D_3$), deren Anode mit der Versorgungsleitung mit Zwischenspannung und deren Katode mit dem vierten Verbindungsknoten verbunden ist.

3. Schaltung nach Anspruch 1 oder 2, wobei die Pegelverschiebungseinrichtung einen Widerstand ($R_3$), dessen eines Ende mit dem zweiten Verbindungsknoten und dessen anderes Ende mit dem dritten Verbindungsknoten verbunden ist, und eine Diode ($D_2$), deren Anode mit dem dritten Verbindungsknoten und deren Katode mit dem vierten Verbindungsknoten verbunden ist, aufweist.

**4.** Schaltung nach Anspruch 1 oder 2, wobei die Pegelverschiebungseinrichtung eine Diode ($D_{21}$), deren Anode mit dem zweiten Verbindungsknoten und deren Katode mit dem dritten Verbindungsknoten verbunden ist, und eine andere Diode ($D_2$), deren Anode mit dem dritten Verbindungsknoten und deren Katode mit dem vierten Verbindungsknoten verbunden ist, aufweist.

**5.** Schaltung nach Anspruch 1 oder 2, wobei die Pegelverschiebungseinrichtung einen Widerstand ($R_3$), dessen eines Ende mit dem zweiten Verbindungsknoten und dessen anderes Ende mit dem dritten Verbindungsknoten verbunden ist, und einen anderen Widerstand ($R_{32}$), dessen eines Ende mit dem dritten Verbindungsknoten und dessen anderes Ende mit dem vierten Verbindungsknoten verbunden ist, aufweist.

**6.** Schaltung nach Anspruch 1 oder 2, wobei die Pegelverschiebungseinrichtung eine Diode ($D_{21}$), deren Anode mit dem zweiten Verbindungsknoten und deren Katode mit dem dritten Verbindungsknoten verbunden ist, und einen Widerstand ($R_{32}$), dessen eines Ende mit dem dritten Verbindungsknoten und dessen anderes Ende mit dem vierten Verbindungsknoten verbunden ist, aufweist.

**Revendications**

**1.** Circuit convertisseur TTL/ECL (logique transistor-transistor/logique à couplage d'émetteur), comprenant une diode à barrière de Schottky ($D_1$), ayant, une cathode reliée à une borne d'entrée (IN) pour un signal TTL et une anode reliée à un premier noeud de complexion, une résistance ($R_1$) reliée par une extrémité à une ligne d'alimentation haute tension (Vcc) et reliée par son autre extrémité audit premier noeud de connexion, un premier transistor ($Q_1$) ayant un collecteur relié à ladite ligne d'alimentation haute tension, une base reliée audit premier noeud de connexion et un émetteur relié à un deuxième noeud de connexion, des moyens de changement de niveau ($R_3$, $D_2$ ; $D_{21}$, $D_2$ ; $R_3$, $R_{32}$ ; $D_{21}$, $R_{32}$) dont une extrémité est reliée audit deuxième noeud de connexion, à un noeud intermédiaire formant un troisième noeud de connexion, et dont l'autre extrémité est reliée à un quatrième noeud de connexion, une source à courant constant (Ics), dont une extrémité est reliée audit quatrième noeud de connexion et dont l'autre extremité est reliée à une ligne d'alimentation basse tension (Vee), un deuxième transistor ($Q_2$) ayant un collecteur relié audit premier noeud de connexion, une base reliée audit troisième noeud de connexion et un émetteur relié, par l'intermédiaire d'une deuxième résistance ($R_2$), à une ligne d'alimentation à tension intermédiaire (GND), et un montage émetteur-suiveur ($Q_3$, $R_4$) connecté entre ladite ligne d'alimentation à tension intermédiaire et ladite ligne d'alimentation basse tension, et ayant une entrée reliée audit quatrième noeud de connexion et une sortie reliée à une borne de sortie (OUT) pour un signal ECL.

**2.** Circuit selon la revendication 1, comprenant en outre une diode ($D_3$), dont l'anode est reliée à ladite ligne d'alimentation à tension intermédiaire et; dont la cathode est reliée audit quatrième noeud de connexion.

**3.** Circuit selon la revendication 1 ou 2, dans lequel lesdits moyens de changement de niveau comprennent une résistance ($R_3$), dont une extrémité est reliée audit deuxième noeud de connexion et dont l'autre extrémité est reliée audit troisième noeud de connexion, et une diode ($D_2$), dont l'anode est reliée, audit troisième noeud de connexion et dont la cathode est reliée audit quatrième noeud de connexion.

**4.** Circuit selon la revendication 1 ou 2, dans lequel lesdits moyens de changement de niveau comprennent une diode ($D_{21}$), dont l'anode est reliée audit deuxième noeud de connexion et dont la cathode est reliée audit troisième noeud de connexion, et une autre diode ($D_2$) dont l'anode est reliée audit troisième noeud de connexion et dont la cathode est reliée audit quatrième noeud de connexion.

**5.** Circuit selon la revendication 1 ou 2, dans lequel lesdits moyens de changement de niveau comprennent une résistance ($R_3$), dont une extrémité est reliée audit deuxième noeud de connexion et dont l'autre extrémité est reliée audit troisième noeud de connexion, et une autre résistance ($R_{32}$) dont une extrémité est reliée audit troisième noeud de connexion et dont l'autre extrémité est reliée audit quatrième noeud de connexion.

**6.** Circuit selon la revendication 1 ou 2, dans lequel lesdits moyens de changement de niveau comprennent une diode ($D_{21}$), dont l'anode est reliée audit deuxième noeud de connexion et dont la cathode est reliée audit troisième noeud de connexion, et une résistance ($R_{32}$) dont une extrémité est reliée audit troisième noeud de connexion et dont l'autre extrémité est reliée audit quatrième noeud de connexion.

# FIGURE 1

# FIGURE 2

# FIGURE 3A

FIGURE 3A — D1, IN, R1, Q1, Q2, R2, D21, D2, LEVEL SHIFT CIRCUIT, Vcc, GND, TO ECL SIGNAL OUTPUT CIRCUIT

# FIGURE 3B

FIGURE 3B — D1, IN, R1, Q1, Q2, R2, R3, R32, LEVEL SHIFT CIRCUIT, Vcc, GND, TO ECL SIGNAL OUTPUT CIRCUIT

# FIGURE 3C

FIGURE 3C — D1, IN, R1, Q1, Q2, R2, D21, R32, LEVEL SHIFT CIRCUIT, Vcc, GND, TO ECL SIGNAL OUTPUT CIRCUIT

# FIGURE 4A

VOLTAGE ⟹

A : TTL LEVEL INPUT SIGNAL

B : BASE POTENTIAL OF Q1

C : CATHODE POTENTIAL OF D2

D : ECL LEVEL OUTPUT SIGNAL

E : REFERENCE VOLTAGE OF ECL LEVEL SIGNAL

# FIGURE 4B

VOLTAGE ⟹

A : TTL LEVEL INPUT SIGNAL

B : BASE POTENTIAL OF Q1

C : CATHODE POTENTIAL OF D2

D : ECL LEVEL OUTPUT SIGNAL

E : REFERENCE VOLTAGE OF ECL LEVEL SIGNAL